(19) **Europäisches Patentamt**
**European Patent Office**
**Office européen des brevets**

(11) **EP 4 431 237 A1**

(12) **EUROPEAN PATENT APPLICATION**

(43) Date of publication:
**18.09.2024 Bulletin 2024/38**

(21) Application number: **24163974.9**

(22) Date of filing: **15.03.2024**

(51) International Patent Classification (IPC):
**B24B 37/24** *(2012.01)*

(52) Cooperative Patent Classification (CPC):
(C-Sets available)
**B24B 37/24; C08G 18/10; C08G 18/42;
C08G 18/44; C08G 18/48; C08G 18/4854;
C08G 18/724; C08G 18/758; C08G 18/7621;
C08J 9/30;** C08G 2110/00; H01L 21/304   (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **17.03.2023 KR 20230034884**

(71) Applicant: **SK enpulse Co., Ltd.
Pyeongtaek-si, Gyeonggi-do 17784 (KR)**

(72) Inventors:
• **JI, Min Gyeong**
**17784 Gyeonggi-do (KR)**
• **YUN, Jong Wook**
**17784 Gyeonggi-do (KR)**
• **SEO, Jangwon**
**17784 Gyeonggi-do (KR)**

(74) Representative: **Dehns**
**St. Bride's House
10 Salisbury Square
London EC4Y 8JD (GB)**

(54) **POLISHING PAD AND PREPARATION METHOD THEREOF**

(57)    The embodiment relates to a polishing pad for use in a chemical mechanical planarization process of semiconductor devices. The polishing pad comprises a top pad layer, wherein the polishing pad has a total biomass content of 1 to 50% by weight as measured according to the ASTM D 6866 standard; thus, it can be environmentally friendly.

[Fig. 1]

**EP 4 431 237 A1**

(52) Cooperative Patent Classification (CPC): (Cont.)

C-Sets
**C08G 18/10, C08G 18/3814**

## Description

### Technical Field

Embodiments relate to a polishing pad for use in a chemical mechanical planarization (CMP) process of semiconductor devices. Specifically, they relate to an environmentally friendly polishing pad as it comprises a biomass component and to a process for preparing the same.

### Background Art

The chemical mechanical planarization (CMP) process in a process for preparing semiconductors refers to a step in which a semiconductor substrate such as a wafer is fixed to a head and in contact with the surface of a polishing pad mounted on a platen, and the platen and the head are relatively moved to planarize the irregularities on the surface of the semiconductor substrate.

In this CMP process, the polishing pad is required to have stable physical properties because it greatly affects the surface processing quality of the semiconductor substrate. In particular, since the polishing rate of the CMP process may vary sensitively depending on the components contained in the polishing pad and their physical properties, it is necessary to optimize the components contained in the polishing pad and their physical properties.

Meanwhile, as environmental problems such as climate change have recently arisen, public opinion is forming that companies should take social responsibility for building a society capable of sustainable development through ESG management such as "carbon neutrality." Accordingly, various companies are attempting to manufacture various products by applying biomass raw materials derived from plants instead of petroleum-based raw materials.

In line with this trend, attempts are needed to increase environmental friendliness by applying biomass raw materials to polishing pads that have been previously manufactured using petroleum-based raw materials. Further, even if such biomass raw materials are used, it is necessary to provide a polishing pad with physical properties that can achieve the level of a polishing rate required in a CMP process.

[Prior Art Document]

(Patent Document 1) Korean Laid-open Patent Publication No. 2018-0044771

### Disclosure of Invention

### Technical Problem

The embodiments aim to provide a polishing pad that is environmentally friendly and has physical properties capable of achieving the polishing rate required in a CMP process.

In addition, the embodiments aim to provide a process for preparing a polishing pad capable of efficiently preparing the polishing pad.

### Solution to Problem

According to an embodiment to solve the above problem, there is provided a polishing pad that comprises a top pad layer prepared from a biomass-containing composition and has a total biomass content of 1 to 50% by weight as measured by the ASTM D 6866 standard.

According to another embodiment, there is provided a process for preparing a polishing pad that comprises preparing a biomass-containing urethane prepolymer from a urethane prepolymer composition comprising an isocyanate raw material and a polyol raw material comprising a bio-polyol; preparing a biomass-containing composition comprising the biomass-containing urethane prepolymer, a curing agent, and a foaming agent; and curing the biomass-containing composition to prepare a top pad layer, wherein the polishing pad has a total biomass content of 1 to 50% by weight as measured by the ASTM D 6866 standard.

### Advantageous Effects of Invention

The polishing pad according to an embodiment is prepared using a composition comprising a biomass raw material, wherein the composition and content of the biomass raw material are optimized to adjust the content of biomass contained in the polishing pad to a certain range, whereby it is possible to have physical properties (e.g., hardness, modulus, and the like) required in a CMP process, along with excellent environmental friendliness.

Accordingly, when a CMP process is carried out using the polishing pad according to an embodiment, a semiconductor substrate (e.g., wafer) with excellent surface processing quality can be provided while a high polishing rate is achieved.

**Brief Description of Drawings**

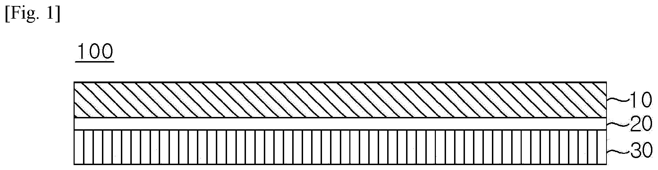

Fig. 1 is a cross-sectional view showing a polishing pad according to an embodiment. (100: polishing pad, 10: top pad layer, 20: adhesive layer, 30: sub pad layer).

**Best Mode for Carrying out the Invention**

Hereinafter, the present invention will be described with reference to embodiments. Here, the embodiments are not limited to what has been disclosed below. The embodiments may be modified into various forms as long as the gist of the invention is not altered.

In the present specification, in the case where an element is mentioned to be formed, connected, or combined on or under another element, it means all of the cases where one element is directly, or indirectly through another element, formed, connected, or combined with another element. In addition, it should be understood that the criterion for the terms on and under of each component may vary depending on the direction in which the object is observed.

In the present specification, the term "comprising" is intended to specify a particular characteristic, region, step, process, element, and/or component. It does not exclude the presence or addition of any other characteristic, region, step, process, element and/or component, unless specifically stated to the contrary.

All numbers and expressions related to the quantities of components, reaction conditions, and the like used herein are to be understood as being modified by the term "about," unless otherwise indicated.

**Polishing pad**

An embodiment provides a polishing pad that comprises a top pad layer and, if necessary, further comprises an adhesive layer and a sub pad layer. The polishing pad according to an embodiment is prepared using a composition comprising a biomass raw material, wherein the composition and content of the biomass raw material are optimized to adjust the content of biomass contained in the polishing pad to a certain range, which will be described in detail hereinafter referring to Fig. 1.

The biomass is an energy source obtained from living organisms. Specifically, it may refer to an energy source including biocarbon (radiocarbon (C14)) obtained from animal and plant resources such as trees, flowers, corn, sugarcane, grass, whale oil, algae, and the like; or organic waste resources such as livestock manure, food waste, sawdust, and the like.

Meanwhile, hereinafter, the described content of biomass (biocarbon) may refer to a value measured in accordance with the ASTM D 6866 standard. The ASTM D 6866 standard is a standard analysis method for determining the content of biomass (biocarbon) in a solid sample, a liquid sample, or a gaseous sample using a radiometric dating method or an accelerator mass spectrometry (AMS) method.

The radiocarbon dating method may comprise the following procedure. Specifically, a sample (specimen) that has been pre-treated (e.g., foreign matters have been removed) is put into a special vacuum device and burned to make carbon dioxide. Next, molten lithium is mixed to prepare lithium carbide, which is then cooled, and lithium carbide is reacted with water to make acetylene gas. The acetylene gas is then purified and converted to benzene using a silica-alumina catalyst. Next, benzene, which is composed of 92% carbon, is mixed with a scintillation chemical material, and then the radioactivity is measured with a liquid scintillation counter for about 2 days.

The accelerator mass spectrometry method may comprise the following procedure. Specifically, a sample (specimen) that has been pre-treated (e.g., foreign matters have been removed) is burned to make purified carbon dioxide, which is then reacted with hydrogen in a special glass vacuum chamber to make graphite. Graphite, which is composed of 100% carbon, is then placed in an accelerator mass spectrometer and measured for radioactivity for about 30 minutes.

Top pad layer

The top pad layer (10) adopted in the polishing pad (100) according to an embodiment serves to polish a semiconductor substrate (e.g., wafer) that is subjected to polishing. Such a top pad layer (10) is prepared from a biomass-containing composition (a composition for forming a top pad layer). Specifically, the top pad layer (10) is prepared (formed) using a composition (A) comprising a biomass raw material, wherein the biomass raw material may be a biomass-containing urethane prepolymer (A1).

The biomass-containing urethane prepolymer (A1) may be a prepolymer obtained through a reaction of a biomass-containing polyol raw material and an isocyanate raw material. Specifically, the biomass-containing urethane prepolymer (A1) may be prepared from a urethane prepolymer composition comprising a polyol raw material (A11) comprising a bio-polyol; and an isocyanate raw material (A12).

The polyol raw material (A11) comprising a bio-polyol may be derived from biomass and comprise biocarbon, while it may not be particularly limited if it is a polyol raw material comprising a bio-polyol having two or more hydroxyl groups (OH). Specifically, the polyol raw material (A11) may comprise a bio-polyol comprising at least one selected from the group consisting of a bio-polymer polyol (A111) and a bio-monomer polyol (A112). For example, the bio-polyol may be composed of the bio-polymer polyol (A111) alone or the bio-monomer polyol (A112) alone, or it may be composed of a mixture of the bio-polymer polyol (A111) and the bio-monomer polyol (A112).

The bio-polymer polyol (A111) is derived from biomass and comprises biocarbon, while it may not be particularly limited if it is a multimolecular bio-polyol having two or more hydroxyl groups (OH). Specifically, the bio-polymer polyol (A111) may comprise at least one selected from the group consisting of a bio-polyether polyol, a bio-polyester polyol, a bio-polycarbonate polyol, and a bio-polycaprolactam polyol. As the bio-polymer polyol (A111) comprises the multimolecular bio-polyol, it is possible to reduce the viscosity of the urethane prepolymer composition to ensure processability while providing a polishing pad (100) with excellent flexibility, elastic restoring force, permanent strain, weatherability, and hydrolysis resistance. For example, the bio-polymer polyol (A111) may be SK Chemical's EcoTRION H2000 or EcoTRION H1000; SK Pucore's BI-550 or B-1184; BASF's Sovermol 1102, Sovermol 1005, Sovermol 805, or Sovermol 815; Noroo's BP-04 or BP-05; Croda's Priplast 2033 or Priplast 1838; Allessa's Velvetol H500, Velvetol H1000, Velvetol H2000, or Velvetol H2700; or a combination thereof.

The bio-polymer polyol (A111) may have a weight average molecular weight of 400 to 3,000 g/mole, specifically, 450 to 2,700 g/mole, 500 to 2,300 g/mole, 600 to 1,800 g/mole, 700 to 1,500 g/mole, or 800 to 1,200 g/mole. In addition, the bio-polymer polyol (A111) may have a hydroxyl group value (OH-value) of 35 to 250 mg KOH/g, specifically, 45 to 230 mg KOH/g, 60 to 200 mg KOH/g, 70 to 180 mg KOH/g, 80 to 150 mg KOH/g, or 90 to 130 mg KOH/g. As the weight average molecular weight and hydroxyl group value (OH-value) of the bio-polymer polyol (A111) are each within the above range, it is possible to provide a polishing pad (100) with excellent flexibility, elastic restoring force, permanent strain, weatherability, and hydrolysis resistance.

Such a bio-polymer polyol (A111) may have a biomass content (the content of biocarbon contained in the bio-polymer polyol (A111)) of 20 to 100% by weight, specifically, 25 to 100% by weight, 40 to 100 % by weight, 50 to 100% by weight, 60 to 100% by weight, 70 to 100% by weight, or 80 to 100% by weight, based on the total weight of the bio-polymer polyol (A111). As the biomass content of the bio-polymer polyol (A111) is within the above range, it is possible to provide a polishing pad (100) with excellent environmental friendliness, along with the physical properties required in a CMP process.

The bio-monomer polyol (A112) is derived from biomass and comprises biocarbon, while it may not be particularly limited if it is a single-molecular bio-polyol having two or more hydroxyl groups (OH). Specifically, the bio-monomer polyol (A112) may comprise at least one selected from the group consisting of bio-ethylene glycol, bio-diethylene glycol, bio-1,2-propylene glycol, bio-1,3-propanediol, bio-2-methyl-1,3-propanediol, bio-1,3-butanediol, bio-1,4-butanediol, bio-2,3-butanediol, bio-n-butanol, bio-isobutanol, bio-1,5-pentanediol, bio-2-octanol, bio-1,9-nonediol, bio-1,10-decanediol, bio-diethylene glycol, and bio-isosorbide. As the bio-monomer polyol (A112) comprises the single-molecular bio-polyol, it is possible to increase the crosslinking density of the urethane prepolymer composition to provide a polishing pad (100) with excellent hardness and durability.

The bio-monomer polyol (A112) may have a weight average molecular weight of 50 to 200 g/mole, specifically, 55 to 180 g/mole, 60 to 150 g/mole, 65 to 130 g/mole, 70 to 100 g/mole, or 75 to 90 g/mole. As the weight average molecular weight of the bio-monomer polyol (A112) is within the above range, it is possible to provide a polishing pad (100) with excellent hardness and durability.

Such a bio-monomer polyol (A112) may have a biomass content (the content of biocarbon contained in the bio-monomer polyol (A112)) of 100% by weight based on the total weight of the bio-monomer polyol (A112). As the biomass content of the bio-monomer polyol (A112) is within the above range, it is possible to provide a polishing pad (100) with excellent environmental friendliness, along with the physical properties required in a CMP process.

The polyol raw material (A11) may further comprise a petroleum-based polyol in addition to the bio-polyol. Specifically, the polyol raw material (A11) may comprise at least one selected from the group consisting of a petroleum-based polymer polyol and a petroleum-based monomer polyol. The petroleum-based polymer polyol may comprise at least one selected from the group consisting of a polyether polyol, a polyester polyol, a polycarbonate polyol, and a polycaprolactam polyol commonly known. The petroleum-based monomer polyol may comprise at least one selected from the group consisting of ethylene glycol, diethylene glycol, 1,2-propylene glycol, 1,3-propanediol, 2-methyl-1,3-propanediol, dipropylene glycol, 1,3-butanediol, 1,4-butanediol, 2,3-butanediol, n-butanol, isobutanol, 1,5-pentanediol, 1,6-hexanediol, 2-octanol, 1,9-nonanediol, 1,10-decanediol, and isosorbide commonly known.

When the polyol raw material (A11) comprises both the bio-polyol (a) and the petroleum-based polyol (b), their mixing ratio (a:b) may be a mole ratio of 1:0.65 to 1:3, a mole ratio of 1:0.65 to 1:1.5, a mole ratio of 1:0.65 to 1: 1.25, a mole ratio of 1:0.65 to 1:0.92, a mole ratio of 1:0.68 to 1:0.90, a mole ratio of 1:0.72 to 1:0.88, a mole ratio of 1:0.75 to 1:0.86, or a mole ratio of 1:0.80 to 1:0.85. As the mixing ratio is within the above range, it is possible to provide a polishing pad (100) with excellent environmental friendliness, along with the physical properties required in a CMP process.

Meanwhile, the isocyanate raw material (A12) may not be particularly limited if it comprises a commonly known petroleum-based isocyanate (A121). Specifically, the isocyanate raw material (A12) may comprise at least one selected from the group consisting of a petroleum-based aromatic diisocyanate, a petroleum-based aliphatic diisocyanate, and a petroleum-based cycloaliphatic diisocyanate. More specifically, the isocyanate raw material (A12) may comprise at least one selected from the group consisting of a petroleum-based aromatic diisocyanate and a petroleum-based cycloaliphatic diisocyanate.

For example, the isocyanate raw material (A12) may comprise at least one selected from the group consisting of toluene diisocyanate, naphthalene-1,5-diisocyanate, para-phenylene diisocyanate, tolidine diisocyanate, 4,4'-diphenylmethane diisocyanate, hexamethylene diisocyanate, 4,4'-methylenedicyclohexyl diisocyanate, and isophorone diisocyanate.

Preferably, the isocyanate raw material (A12) may comprise at least one selected from the group consisting of toluene diisocyanate (TDI) and 4,4'-methylenedicyclohexyl diisocyanate (H12MDI). As the isocyanate raw material (A12) comprises the toluene diisocyanate (TDI), the 4,4'-methylenedicyclohexyl diisocyanate (H12MDI), or a mixture thereof, a hard segment can be formed, whereby it is possible to provide a polishing pad (100) having the required level of hardness. When the toluene diisocyanate (TDI) (x) and the 4,4'-methylenedicyclohexyl diisocyanate (H12MDI) (y) are mixed, their mixing ratio (x:y) is not particularly limited, but it may specifically be a weight ratio of 3:1 to 20:1, a weight ratio of 5:1 to 18: 1, a weight ratio of 7:1 to 16:1, or a weight ratio of 8:1 to 13:1.

Meanwhile, the isocyanate raw material (A12) may comprise a bio-isocyanate (A122). Specifically, the isocyanate raw material (A12) may comprise the petroleum-based isocyanate (A121) and the bio-isocyanate (A122). The bio-isocyanate (A122) is derived from biomass and comprises biocarbon, while it may not be particularly limited if it is a bio-isocyanate having two or more isocyanate groups (NCO). Specifically, the bio-isocyanate (A122) may comprise bio-1,5-pentamethylene diisocyanate. For example, D-370N or D-376N of STABiO may be used as the bio-isocyanate (A122).

The bio-isocyanate (A122) may have an isocyanate end group content (NCO%) of 20 to 30% by weight, specifically, 21 to 28% by weight, 22 to 26% by weight, or 23 to 25% by weight. As the NCO% of the bio-isocyanate (A122) is within the above range, it is possible to provide a polishing pad (100) with excellent hardness and durability.

Such a bio-isocyanate (A122) may have a biomass content (the content of biocarbon contained in the bio-isocyanate (A122)) of 50 to 100% by weight, specifically, 55 to 95% by weight, 60 to 90 % by weight, 63 to 80% by weight, or 65 to 75% by weight, based on the total weight of the bio-isocyanate (A122). As the biomass content of the bio-isocyanate (A122) is within the above range, it is possible to provide a polishing pad (100) with excellent environmental friendliness, along with the physical properties required in a CMP process.

Meanwhile, in the reaction of the polyol raw material (A11) (z) and the isocyanate raw material (A12) (w), the reaction ratio (z:w) of the polyol raw material (A11) (z) and the isocyanate raw material (A12) (w) is not particularly limited. However, in light of the overall physical properties of the top pad layer (10), it may be a weight ratio of 1:2 to 1:14, a weight ratio of 1:3 to 1:12, a weight ratio of 1:4 to 1:10, or a weight ratio of 1:5 to 1:8.

In addition, the ratio (M) of the number of moles of the bio-containing raw material to the total number of moles of the polyol raw material (A11) and the isocyanate raw material (A12) may be 0.11 to 0.93, 0.11 to 0.90, 0.12 to 0.85, 0.12 to 0.80, 0.13 to 0.75, 0.13 to 0.70, 0.14 to 0.65, 0.14 to 0.60, 0.15 to 0.55, 0.15 to 0.50, 0.16 to 0.45, 0.16 to 0.42, or 0.17 to 0.38. Specifically, the ratio (M) may be a value calculated according to the following Equation 1. As the ratio (M) is within the above range, it is possible to provide a polishing pad (100) with excellent environmental friendliness, along with the physical properties required in a CMP process.

[Equation 1]

$$M = (M_{BP1} + M_{BI1})/(M_{BP1} + M_{P2} + M_{BI1} + M_{I2})$$

In Equation 1, $M_{BP1}$ is the number of moles (total number of moles) of the biopolyols contained in the urethane prepolymer composition,

$M_{P2}$ is the number of moles (total number of moles) of the petroleum-based polyols contained in the urethane prepolymer composition,

$M_{BI1}$ is the number of moles (total number of moles) of the bio-isocyanates contained in the urethane prepolymer composition, and
$M_{I2}$ is the number of moles (total number of moles) of the petroleum-based isocyanates contained in the urethane prepolymer composition.

The biomass-containing urethane prepolymer (A1) obtained by the reaction of the polyol raw material (A11) and the isocyanate raw material (A12) may have a biomass (biocarbon) content of 4 to 80% by weight. Specifically, the biomass content of the biomass-containing urethane prepolymer (A1) may be 4 to 78% by weight, 7 to 76% by weight, 8 to 74% by weight, 9 to 72% by weight, 10 to 69% by weight, 25 to 67% by weight, or 45 to 65 w% by weight, based on the total weight of the biomass-containing urethane prepolymer (A1). As the biomass content of the biomass-containing urethane prepolymer (A1) is within the above range, it is possible to provide a polishing pad (100) with excellent environmental friendliness, along with the physical properties required in a CMP process.

The biomass-containing urethane prepolymer (A1) may have a weight average molecular weight of 500 to 1,500 g/mole, specifically, 600 to 1,400 g/mole, 700 to 1,300 g/mole, or 800 to 1,200 g/mole. In addition, the biomass-containing urethane prepolymer (A1) may have an isocyanate end group content (NCO%) of 6 to 14% by weight, specifically, 6.5 to 13% by weight, 7 to 12% by weight, 7.5 to 11% by weight, or 8 to 10% by weight. As the weight average molecular weight and NCO% of the biomass-containing urethane prepolymer (A1) are each within the above range, it is possible to provide a polishing pad (100) with an excellent polishing rate in a CMP process.

Meanwhile, the composition (A) for forming the top pad layer (10), which comprises the biomass-containing urethane prepolymer (A1), may further comprise a curing agent (A2) and a foaming agent (A3).

The curing agent (A2) may comprise a compound that carries out a curing reaction with the biomass-containing urethane prepolymer (A1). Specifically, the curing agent (A2) may comprise at least one selected from the group consisting of an aromatic amine, an aliphatic amine, an aromatic alcohol, and an aliphatic alcohol. More specifically, the curing agent (A2) may comprise at least one selected from the group consisting of 4,4'-methylenebis(2-chloroaniline), diethyltoluenediamine, diaminodiphenylmethane, dimethylthio-toluene diamine, propanediol bis-p-aminobenzoate, diaminodiphenyl sulphone, m-xylylenediamine, isophoronediamine, ethylenediamine, diethylenetriamine, triethylenetetramine, polypropylenediamine, polypropylenetriamine, and bis(4-amino-3-chlorophenyl)methane.

The content of the curing agent (A2) may be 15 to 55 parts by weight, specifically, 20 to 50 parts by weight, 25 to 45 parts by weight, or 30 to 40 parts by weight, relative to 100 parts by weight of the biomass-containing urethane prepolymer (A1). As the content of the curing agent (A2) is within the above range, it may be more advantageous for achieving a polishing pad (100) with excellent physical properties.

Meanwhile, the reaction ratio (curing reaction ratio) of the biomass-containing urethane prepolymer (A1) and the curing agent (A2) is not particularly limited, but it may specifically be an equivalent ratio of 1:0.5 to 1: 1.3, an equivalent ratio of 1:0.6 to 1: 1.2, an equivalent ratio of 1:0.7 to 1:1.1, or an equivalent ratio of 1:0.8 to 1:1. As the curing reaction is carried out at the above reaction ratio, the curing reaction is optimized, whereby it is possible to provide a polishing pad (100) with the physical properties (hardness and modulus) required in a CMP process.

The foaming agent (A3) is for forming a pore structure in the top pad layer (10) and may comprise at least one selected from the group consisting of a solid phase foaming agent, a liquid phase foaming agent, and a gas phase foaming agent (e.g., inert gases such as nitrogen, argon, helium, and the like). Specifically, the foaming agent (A3) may preferably be a solid phase foaming agent comprising expandable particles.

The expandable particles are particles having a characteristic that can be expanded by heat or pressure. The size thereof in a final top pad layer may be determined by heat or pressure applied in the process of preparing the top pad layer (10). Specifically, the expandable particles may comprise thermally expanded particles, unexpanded particles, or a combination thereof. The thermally expanded particles are particles expanded in advance by heat. They may refer to particles whose final size is determined when expanded by heat or pressure applied during the process of preparing the top pad layer (10). The expandable particles may comprise a shell of a resin; and an expansion-inducing component encapsulated inside the shell.

The shell of a resin may comprise a thermoplastic resin. Specifically, the thermoplastic resin may be at least one selected from the group consisting of a vinylidene chloride-based copolymer, an acrylonitrile-based copolymer, a methacrylonitrile-based copolymer, and an acrylic-based copolymer.

The expansion-inducing component may comprise at least one selected from the group consisting of a hydrocarbon compound, a chlorofluoro compound, and a tetraalkylsilane compound.

Specifically, the hydrocarbon compound may comprise at least one selected from the group consisting of ethane, ethylene, propane, propene, n-butane, isobutane, n-butene, isobutene, n-pentane, isopentane, neopentane, n-hexane, heptane, and petroleum ether.

The chlorofluoro compound may comprise at least one selected from the group consisting of trichlorofluoromethane ($CCl_3F$), dichlorodifluoromethane ($CCl_2F_2$), chlorotrifluoromethane ($CClF_3$), and dichlorotetrafluoroethane ($C_2Cl_2F_4$).

The tetraalkylsilane compound may comprise at least one selected from the group consisting of tetramethylsilane, trimethylethylsilane, trimethylisopropylsilane, and trimethyl-n-propylsilane.

Such a solid phase foam agent may have an average particle size of 5 to 200 $\mu$m, specifically, 10 to 100 $\mu$m, 15 to 70 $\mu$m, or 20 to 45 $\mu$m. Here, when the solid phase foaming agent comprises the thermally expanded particles as the expandable particles, the average particle diameter may refer to the average particle diameter of the thermally expanded particles themselves. Here, when the solid phase foaming agent comprises the unexpanded particles as the expandable particles, the average particle diameter may refer to the average particle diameter of the particles upon expansion by heat or pressure.

The content of the solid phase foaming agent may be 0.5 to 10 parts by weight, specifically, 0.7 to 8 parts by weight, 0.9 to 6 parts by weight, or 1 to 5 parts by weight, relative to 100 parts by weight of the biomass-containing urethane prepolymer (A1). As the content of the solid phase foaming agent is within the above range, it may be more advantageous for achieving a polishing pad with excellent physical properties.

In addition, the composition (A) for forming the top pad layer (10), which comprises the biomass-containing urethane prepolymer (A1), may further comprise additives such as a surfactant and a reaction rate controlling agent.

The surfactant is not particularly limited, but it may specifically be a silicone-based surfactant.

The reaction rate controlling agent is not particularly limited, but it may specifically comprise at least one selected from the group consisting of triethylenediamine, dimethylethanolamine, tetramethylbutanediamine, 2-methyl-triethylenediamine, dimethylcyclohexylamine, triethylamine, triisopropanolamine, 1,4-diazabicyclo(2,2,2)octane, bis(2-methylaminoethyl) ether, trimethylaminoethylethanolamine, N,N,N,N,N"-pentamethyldiethyldimethylaminoethylamine, dimethylaminopropylamine, benzyldimethylamine, N-ethylmorpholine, N,N-dimethylaminoethylmorpholine, N,N-dimethylcyclohexylamine, 2-methyl-2-azanobornene, dibutyltin dilaurate, stannous octoate, dibutyltin diacetate, dioctyltin diacetate, dibutyltin maleate, dibutyltin bis-2-ethylhexanoate, and dibutyltin dimercaptide.

The top pad layer (10) prepared from the composition (A) comprising such a biomass-containing urethane prepolymer (A1) may have a biomass (biocarbon) content of 2 to 70% by weight. Specifically, the biomass content of the top pad layer (10) may be 3 to 65% by weight, 5 to 60% by weight, 6 to 58% by weight, 7 to 56% by weight, 8 to 54 w% by weight, 20 to 52% by weight, or 35 to 50% by weight, based on the total weight of the top pad layer (10). As the biomass content of the top pad layer (10) is within the above range, it is possible to provide a polishing pad (100) with excellent environmental friendliness, along with the physical properties required in a CMP process.

The thickness of the top pad layer (10) is not particularly limited, but it may specifically be 0.5 to 5 mm, 0.8 to 4 mm, 1 to 3 mm, or 1.5 to 2.5 mm. In addition, the hardness (Shore D) of the top pad layer (10) is not particularly limited, but it may specifically be 45 to 70, 50 to 68, 53 to 65, or 56 to 60. In addition, the average size of pores formed in the top pad layer (10) is not particularly limited, but it may specifically be 10 to 40 $\mu$m, 15 to 35 $\mu$m, 18 to 30 $\mu$m, or 20 to 25 $\mu$m. As the thickness, hardness, and average pore size of the top pad layer (10) are each within the above range, a CMP process can be carried out stably, and the polishing pad (100) can be made lighter.

Adhesive layer

The adhesive layer (20) further adopted in the polishing pad (100) according to an embodiment is provided between the top pad layer (10) and the sub pad layer (30) and serves to bond the top pad layer (10) and the sub pad layer (30). Further, the adhesive layer (20) may also serve to prevent a polishing slurry supplied to the top pad layer (10) from leaking into the sub pad layer (30). The adhesive layer (20) may be prepared (formed) using a hot melt adhesive composition.

The hot melt adhesive composition may comprise a commonly known hot melt adhesive. Specifically, the hot melt adhesive may comprise at least one selected from the group consisting of a polyurethane resin, a polyester resin, an ethylene-vinyl acetate resin, a polyamide resin, and a polyolefin resin.

The thickness of the adhesive layer (20) is not particularly limited, but it may specifically be 5 to 30 $\mu$m, 10 to 30 $\mu$m, 20 to 27 $\mu$m, or 23 to 25 $\mu$m. As the thickness of the adhesive layer (20) is within the above range, the required level of bonding strength (adhesive strength) between the top pad layer (10) and the sub pad layer (30) can be secured.

Sub pad layer

The sub pad layer (30) further adopted in the polishing pad (100) according to an embodiment is provided under the top pad layer (10) and serves to stably support the top pad layer (10) and to absorb and/or disperse an impact applied to the top pad layer (10). The sub pad layer (30) may be prepared (formed) using a nonwoven fabric, suede, or a porous pad.

The thickness of the sub pad layer (30) is not particularly limited, but it may specifically be 0.5 to 4 mm, 0.6 to 3.5 mm, 0.8 to 3 mm, or 1 to 2 mm. In addition, the hardness (Asker C) of the sub pad layer (30) is not particularly limited, but it may specifically be 55 to 90, 60 to 85, 65 to 80, or 70 to 75. As the thickness and hardness of the sub pad layer (30) are each within the above range, it can stably support the top pad layer (10), and the polishing pad (100) can be made lighter.

The polishing pad (100) according to an embodiment may have excellent environmental friendliness as the top pad layer (10) is prepared from a biomass-containing composition. In addition, the composition and content of each of the polymer raw materials and the isocyanate raw materials contained in the biomass-containing composition used in the preparation of the top pad layer (10) in the polishing pad (100) according to an embodiment are optimally controlled to comprise a biomass content in a specific range. As a result, it has the required physical properties in a CMP process, and the polishing rate and pad cut rate can be excellent.

Specifically, the polishing pad (100) according to an embodiment may have a biomass (biocarbon) content of 1 to 50% by weight based on the total weight of the polishing pad (100). Specifically, the biomass content of the polishing pad (100) may be 2 to 50% by weight, 3 to 50% by weight, 4 to 50% by weight, 5 to 50% by weight, 6 to 50% by weight, 7 to 50% by weight, 8 to 50% by weight, 2 to 45% by weight, 3 to 42% by weight, 4 to 38% by weight, 4.5 to 36% by weight, 5 to 34% by weight, 8 to 32% by weight, 15 to 33% by weight, or 25 to 32% by weight, based on the total weight of the polishing pad (100). As the biomass content of the polishing pad (100) is within the above range, it is possible to provide a polishing pad (100) with very high environmental friendliness, along with excellent polishing rate, pad cut rate, and the like in a CMP process.

Meanwhile, the polishing pad (100) according to an embodiment may have a compressibility (%) of 0.3 to 1.8%, 0.4 to 1.6%, 0.5 to 1.5%, 0.6 to 1.4%, or 0.8 to 1.3%. The compressibility may be calculated by placing a weight of 85 g on the polishing pad (e.g. with a thickness of 3.32 mm, a width of 25 mm, and a length of 25 mm) for 30 seconds, measuring the thickness (A) thereof (e.g. using a dial thickness gauge such as Yasuda, 129-E), placing an additional weight of 800 g (i.e. in total a weight of 85 g and a weight of 800 g) thereon for 3 minutes to measure the thickness (B), and calculating the compressibility as ((A - B)/A $\times$ 100).

In addition, the polishing pad (100) according to an embodiment may have a polishing rate (Å/min) in a CMP process of 1,900 to 4,200 Å/min, 2,500 to 4,150 Å/min, 3,000 to 4,100 Å/min, 3,500 to 4,050 Å/min, or 4,000 to 4,040 Å/min. The polishing rate may be measured as follows:

The polishing pad was fixed to the platen of CMP equipment, and a silicon wafer (diameter: 300 mm) was set with the silicon oxide layer thereof facing downward. Then, a CMP process was carried out. Specifically, the silicon oxide layer was polished under a polishing load of 4.0 psi while the platen was rotated at a speed of 150 rpm for 60 seconds and a calcined silica slurry was supplied onto the polishing pad at a rate of 250 ml/minute. Upon completion of the polishing, the silicon wafer was detached from the carrier, mounted in a spin dryer, washed with deionized water, and then dried for 15 seconds with nitrogen. The difference in thickness before and after polishing was measured, e.g. using a light interference thickness measurement device (Keyence, SI-F80R) for the dried silicon wafer, and the polishing rate was calculated according to the following Equation 2:

[Equation 2]

Polishing rate (Å/min) = polished thickness of a silicon wafer (silicon oxide layer) (Å) / polishing time (minute).

In addition, the polishing pad (100) according to an embodiment may have a pad cut rate ($\mu$m/hr) of 31 to 42 $\mu$m/hr, 31.5 to 41 $\mu$m/hr, 33 to 40.5 $\mu$m/hr, 35 to 40 $\mu$m/hr, or 38 to 39.5 $\mu$m/hr. The pad cut rate may be measured as follows:

The polishing pad was pre-conditioned with deionized water for 10 minutes and then conditioned while deionized water was sprayed for 1 hour to measure the change in thickness of the polishing pad. Here, the equipment used for conditioning may be CTS AP-300HM. The conditioning pressure may be 6 lbf, the rotational speed may be 100 to 110 rpm, and the disk used for conditioning may be Sasol LPX-DS2.

**Process for preparing a polishing pad**

An embodiment provides a process for preparing a polishing pad capable of efficiently preparing the polishing pad described above, below, or in the claims. Specifically, the process for preparing a polishing pad according to an embodiment comprises preparing a biomass-containing urethane prepolymer from a urethane prepolymer composition comprising an isocyanate raw material and a polyol raw material comprising a bio-polyol; preparing a biomass-containing composition comprising the biomass-containing urethane prepolymer, a curing agent, and a foaming agent; and curing the biomass-containing composition to prepare a top pad layer, wherein the polishing pad has a total biomass content of 1 to 50% by weight as measured by the ASTM D 6866 standard.

Specifically, the step of preparing a biomass-containing urethane prepolymer may be carried out by charging a urethane prepolymer composition comprising the polyol raw material and the isocyanate raw material into a reactor and reacting the urethane prepolymer composition. The reaction conditions are not particularly limited, but the reaction temperature may be 70 to 90°C (specifically 75 to 85°C), and the reaction time may be 1 to 4 hours (specifically 2 to 3 hours). Meanwhile, the description of each of the polyol raw material and the isocyanate raw material is the same as the description of the polyol raw material (A11) and the isocyanate raw material (A12) described above and therefore shall be omitted.

The step of preparing a biomass-containing composition may be carried out by filling the biomass-containing urethane prepolymer, a curing agent, and a foaming agent into the respective injection lines and allowing them to be mixed. The mixing may specifically be carried out at a speed of 1,000 to 10,000 rpm, 2,500 to 8,500 rpm, or 4,000 to 7,000 rpm. Here, the foaming agent may be mixed via an injection line separate from the injection line for the biomass-containing urethane prepolymer, or it may be mixed with the biomass-containing urethane prepolymer in advance before the biomass-containing urethane prepolymer is filled into the injection line. Meanwhile, the description of each of the biomass-containing urethane prepolymer, the curing agent, and the foaming agent is the same as the description of the biomass-containing urethane prepolymer (A1), the curing agent (A2), and the foaming agent (A3) described above and therefore will be omitted.

The step of preparing a top pad layer may be carried out by injecting the biomass-containing composition into a mold and subjecting it to a curing reaction. The curing reaction conditions are not particularly limited, but the curing reaction temperature may be 60 to 130°C (specifically 75 to 100°C), and the mold pressure may be 50 to 260 kg/m$^2$ (specifically 80 to 180 kg/m$^2$).

The process for preparing a polishing pad according to an embodiment may further comprise preparing an adhesive layer and a sub pad layer after preparing the top pad layer. In addition, a step of cutting the surface of the top pad layer, a step of machining a groove on the surface of the top pad layer, a step of inspecting the polishing pad, a step of packaging the polishing pad, or the like may be further performed. A typical method of preparing a polishing pad may be adopted in these steps.

**Mode for the Invention**

Hereinafter, the present embodiments will be described in detail with reference to Examples, but the scope of the present embodiments is not limited to the Examples.

**[Example 1]**

Example 1-1: Preparation of a biomass-containing urethane prepolymer

A four-neck flask was charged with 165 g of toluene diisocyanate (TDI) and 25 g of 4,4'-methylenedicyclohexyl diisocyanate (H12MDI) as an isocyanate raw material; and 285 g of a bio-polymer polyol (ECOTRION H1000, SK Chemical (a molecular weight of 1,000 g/mole, an OH-value of 102.0 to 124.7, and a biomass content of 100% by weight based on the total weight of the bio-polymer polyol)) and 25 g of diethylene glycol as a polyol raw material, which was reacted at 80°C for 3 hours to prepare a biomass-containing urethane prepolymer with an NCO% of 9%.

Example 1-2: Preparation of a top pad layer

In a casting machine equipped with an injection line for inert gas, the biomass-containing urethane prepolymer prepared in Example 1-1 was filled in the prepolymer tank, bis(4-amino-3-chlorophenyl) methane (Ishihara) was filled in the curing agent tank, and nitrogen (N$_2$) was used as an inert gas. Meanwhile, 1 part by weight of a solid phase foaming agent (AkzoNobel) and 1 part by weight of a silicone-based surfactant (Evonik) relative to 100 parts by weight of the urethane prepolymer were fed through separate lines to be mixed with the urethane prepolymer.

The raw materials were stirred while they were fed to the mixing head at constant rates through the respective injection lines. In such an event, the urethane prepolymer and the curing agent were fed at an equivalent ratio of 1:1, and nitrogen (N$_2$), an inert gas, was injected at a rate of 0.5 to 1.5 liters/minute. The mixed raw materials were injected into a mold (1,000 mm × 1,000 mm × 3 mm) preheated to 80°C at a charge rate of 10 kg/minute and cast to obtain a molded article. Thereafter, the top and bottom of the molded article were each ground by a thickness of 0.5 mm to obtain a top pad (top pad layer) having a thickness of 2 mm (a specific gravity of 0.82 g/cc and an average pore size of 23.6 μm).

Example 1-3: Preparation of a polishing pad

A sub pad (a thickness of 1.1 mm) was prepared in which a polyester fiber nonwoven fabric was impregnated with a polyurethane resin. Next, the top pad prepared in Example 1-2 and the sub pad were combined using a hot melt adhesive to prepare a polishing pad (a thickness of 3.32 mm) having a structure of a top pad layer, an adhesive layer, and a sub pad layer.

**[Example 2]**

Example 2-1: Preparation of a biomass-containing urethane prepolymer

A four-neck flask was charged with 180 g of toluene diisocyanate (TDI) and 25 g of 4,4'-methylenedicyclohexyl diisocyanate (H12MDI) as an isocyanate raw material; and 265 g of a bio-polymer polyol (ECOTRION H1000, SK Chemical (a molecular weight of 1,000 g/mole, an OH-value of 102.0 to 124.7, and a biomass content of 100% by weight based on the total weight of the bio-polymer polyol)) and 25 g of bio-1,3-propanediol (a molecular weight of 76 g/mole and a biomass content of 100% by weight based on the total weight of bio-1,3-propanediol) as a polyol raw material, which was reacted at 80°C for 3 hours to prepare a biomass-containing urethane prepolymer with an NCO% of 9%.

Example 2-2: Preparation of a top pad layer

Atop pad (top pad layer) (a specific gravity of 0.81 g/cc and an average pore size of 23.1 $\mu$m) was prepared in the same manner as in Examples 1-2, except that the urethane prepolymer prepared in Examples 2-1 was used instead of the urethane prepolymer prepared in Examples 1-1.

Example 2-3: Preparation of a polishing pad

A polishing pad (a thickness of 3.32 mm) having a structure of a top pad layer, an adhesive layer, and a sub pad layer was prepared in the same manner as in Examples 1-3, except that the top pad prepared in Examples 2-2 was used instead of the top pad prepared in Examples 1-2.

**[Example 3]**

Example 3-1: Preparation of a biomass-containing urethane prepolymer

A four-neck flask was charged with 175 g of toluene diisocyanate (TDI) and 25 g of 4,4'-methylenedicyclohexyl diisocyanate (H12MDI) as an isocyanate raw material; and 260 g of polytetramethylene ether glycol and 25 g of bio-1,3-propanediol (a molecular weight of 76 g/mole and a biomass content of 100% by weight based on the total weight of bio-1,3-propanediol) as a polyol raw material, which was reacted at 80°C for 3 hours to prepare a biomass-containing urethane prepolymer with an NCO% of 9%.

Example 3-2: Preparation of a top pad layer

Atop pad (top pad layer) (a specific gravity of 0.82 g/cc and an average pore size of 23.4 $\mu$m) was prepared in the same manner as in Examples 1-2, except that the urethane prepolymer prepared in Examples 3-1 was used instead of the urethane prepolymer prepared in Examples 1-1.

Example 3-3: Preparation of a polishing pad

A polishing pad (a thickness of 3.32 mm) having a structure of a top pad layer, an adhesive layer, and a sub pad layer was prepared in the same manner as in Examples 1-3, except that the top pad prepared in Examples 3-2 was used instead of the top pad prepared in Examples 1-2.

**[Comparative Example 1]**

Comparative Example 1-1: Preparation of a biomass-containing urethane prepolymer

A four-neck flask was charged with 30 g of 4,4'-methylenedicyclohexyl diisocyanate (H12MDI) and 365 g of a bio-isocyanate (STABiO D-376N, MITSUI CHEMICALS (a molecular weight of 350 g/mole and a biomass content of 67% by weight based on the total weight of the bio-isocyanate)) as an isocyanate raw material; and 60 g of a bio-polymer polyol (ECOTRION H1000, SK Chemical (a molecular weight of 1,000 g/mole, an OH-value of 102.0 to 124.7, and a biomass content of 100% by weight based on the total weight of the bio-polymer polyol)) and 45 g of bio-1,3-propanediol (a molecular weight of 76 g/mole and a biomass content of 100% by weight based on the total weight of bio-1,3-propanediol) as a polyol raw material, which was reacted at 80°C for 3 hours to prepare a biomass-containing urethane prepolymer with an NCO% of 9%.

Comparative Example 1-2: Preparation of a top pad layer

Atop pad (top pad layer) (a specific gravity of 0.81 g/cc and an average pore size of 23.1 $\mu$m) was prepared in the same manner as in Examples 1-2, except that the urethane prepolymer prepared in Comparative Examples 1-1 was used instead of the urethane prepolymer prepared in Examples 1-1.

Comparative Example 1-3: Preparation of a polishing pad

A polishing pad (a thickness of 3.32 mm) having a structure of a top pad layer, an adhesive layer, and a sub pad layer was prepared in the same manner as in Examples 1-3, except that the top pad prepared in Comparative Examples 1-2 was used instead of the top pad prepared in Examples 1-2.

**[Comparative Example 2]**

Comparative Example 2-1: Preparation of a biomass-containing urethane prepolymer

A four-neck flask was charged with 140 g of toluene diisocyanate (TDI) and 20 g of 4,4'-methylenedicyclohexyl diisocyanate (H12MDI) as an isocyanate raw material; and 340 g of polytetramethylene ether glycol as a polyol raw material, which was reacted at 80°C for 3 hours to prepare a biomass-containing urethane prepolymer with an NCO% of 9%.

Comparative Example 2-2: Preparation of a top pad layer

Atop pad (top pad layer) (a specific gravity of 0.81 g/cc and an average pore size of 22.2 $\mu$m) was prepared in the same manner as in Examples 1-2, except that the urethane prepolymer prepared in Comparative Examples 2-1 was used instead of the urethane prepolymer prepared in Examples 1-1.

Comparative Example 2-3: Preparation of a polishing pad

A polishing pad (a thickness of 3.32 mm) having a structure of a top pad layer, an adhesive layer, and a sub pad layer was prepared in the same manner as in Examples 1-3, except that the top pad prepared in Comparative Examples 2-2 was used instead of the top pad prepared in Examples 1-2.

**[Test Example 1] Analysis of biomass content**

The content of biomass (biocarbon) contained in each of the urethane prepolymer, top pad layer, and polishing pad (sample size: a width of 5 cm and a length of 5 cm) was analyzed in accordance with the ASTM D 6866 standard (radiocarbon dating method applied). The results are shown in Table 1 below.

[Table 1]

|  | Ex. 1 | Ex. 2 | Ex. 3 | C. Ex. 1 | C. Ex. 2 |
|---|---|---|---|---|---|
| Based on the total weight of the polishing pad | 27.5% by weight | 30.5% by weight | 2% by weight | 60% by weight | 0% by weight |
| Based on the total weight of the top pad layer | 42.5% by weight | 47% by weight | 3% by weight | 77% by weight | 0% by weight |
| Based on the total weight of the urethane prepolymer | 54% by weight | 60% by weight | 4% by weight | 98% by weight | 0% by weight |

Referring to Table 1 above, in the polishing pads of Examples 1 to 3 according to an embodiment, the biomass content satisfied all the range of 1 to 50% by weight based on the total weight of the polishing pad, the range of 2 to 70% by weight based on the total weight of the top pad layer, and the range of 4 to 80% by weight based on the total weight of the urethane prepolymer, whereas the biomass content failed to satisfy the above ranges in Comparative Examples 1 and 2.

**[Test Example 2] Evaluation of physical properties**

The top pads, sub pads, and polishing pads prepared in Examples 1 to 3 and Comparative Examples 1 and 2 were each evaluated for the following physical properties. The results are shown in Table 2 below.

### 1. Hardness

The top pads (a thickness of 2 mm, a width of 5 cm, and a length of 5 cm) and the sub pads (a thickness of 1.1 mm, a width of 5 cm, and a length of 5 cm) were each stored at 25°C for 12 hours, and a hardness meter was used to measure Shore D hardness and Asker C hardness.

### 2. Tensile strength

Each top pad (a thickness of 2 mm, a length of 4 cm, and a width of 1 cm) was measured for the highest strength value just before fracture at a speed of 50 mm/minute using a universal test machine (UTM).

### 3. Elongation

Each top pad (a thickness of 2 mm, a length of 4 cm, and a width of 1 cm) was measured for the maximum deformation length immediately before fracture using a universal test machine (UTM), and the ratio of the maximum deformation length to the initial length was obtained in a percentage (%).

### 4. Compressibility

A weight of 85 g was placed on each polishing pad (a thickness of 3.32 mm, a width of 25 mm, and a length of 25 mm) using a dial thickness gauge (Yasuda, 129-E) device for 30 seconds to measure the thickness (A). An additional weight of 800 g (a weight of 85 g and a weight of 800 g together) was placed thereon for 3 minutes to measure the change in thickness (B). The compressibility (($A - B$)/$A \times 100$) was then calculated.

### 5. Polishing rate

Each polishing pad was fixed to the platen of CMP equipment, and a silicon wafer (diameter: 300 mm) was set with the silicon oxide layer thereof facing downward. Then, a CMP process was carried out. Specifically, the silicon oxide layer was polished under a polishing load of 4.0 psi while the platen was rotated at a speed of 150 rpm for 60 seconds and a calcined silica slurry was supplied onto the polishing pad at a rate of 250 ml/minute. Upon completion of the polishing, the silicon wafer was detached from the carrier, mounted in a spin dryer, washed with deionized water, and then dried for 15 seconds with nitrogen. The difference in thickness before and after polishing was measured using a light interference thickness measurement device (Keyence, SI-F80R) for the dried silicon wafer, and the polishing rate was calculated according to the following Equation 2.

Polishing rate (Å/min) = polished thickness of a silicon wafer (silicon oxide layer) (Å) / polishing time (minute)                    [equation 2]

### 6. Pad cut rate

Each polishing pad was pre-conditioned with deionized water for 10 minutes and then conditioned while deionized water was sprayed for 1 hour to measure the change in thickness of the polishing pad. Here, the equipment used for conditioning was CTS AP-300HM. The conditioning pressure was 6 lbf, the rotational speed was 100 to 110 rpm, and the disk used for conditioning was Sasol LPX-DS2.

[Table 2]

| | Ex. 1 | Ex. 2 | Ex. 3 | C. Ex. 1 | C. Ex. 2 |
|---|---|---|---|---|---|
| Top pad hardness (Shore D) | 58.2 | 59.3 | 58.5 | 45.3 | 58 |
| Top pad tensile strength (N/mm$^2$) | 22.3 | 22.2 | 21.9 | 16.2 | 22 |

(continued)

|  | Ex. 1 | Ex. 2 | Ex. 3 | C. Ex. 1 | C. Ex. 2 |
|---|---|---|---|---|---|
| Top pad elongation (%) | 107.5 | 103.7 | 100.8 | 253.0 | 98.2 |
| Sub pad hardness (Asker C) | 70 | 70 | 70 | 70 | 70 |
| Polishing pad compressibility (%) | 1.05 | 1.05 | 1.05 | 1.05 | 1.05 |
| Polishing rate (Å/min) | 4033 | 4030 | 4026 | 1866 | 4028 |
| Pad cut rate (μm/hr) | 38.6 | 39.2 | 38.4 | 30.1 | 38.9 |

Referring to Table 2 above, the polishing pads of Examples 1 to 3, in which the total biomass content was adjusted to the range of the embodiment, had excellent overall physical properties, whereas the polishing pad of Comparative Example 1, which was outside the range of the embodiment, had significantly deteriorated physical properties. In addition, even though the polishing pads of Examples 1 to 3 were prepared using bio-polyol raw materials, they showed physical properties equal to, or higher than, those of the polishing pad of Comparative Example 2 prepared using petroleum-based polyol raw materials. As a result, the embodiment can provide a polishing pad that has excellent physical properties while exhibiting environmental friendliness.

**Claims**

1. A polishing pad, which comprises a top pad layer prepared from a biomass-containing composition and has a total biomass content of 1 to 50% by weight as measured by the ASTM D 6866 standard.

2. The polishing pad of claim 1, wherein the biomass content of the top pad layer is 2 to 70% by weight based on the total weight of the top pad layer.

3. The polishing pad of claim 1 or 2, wherein the composition comprises a biomass-containing urethane prepolymer, and the biomass-containing urethane prepolymer is prepared from a urethane prepolymer composition comprising an isocyanate material; and a polyol material comprising a bio-polyol.

4. The polishing pad of claim 3, wherein the biomass content of the biomass-containing urethane prepolymer is 4 to 80% by weight based on the total weight of the biomass-containing urethane prepolymer.

5. The polishing pad of claim 3 or 4, wherein the bio-polyol comprises at least one selected from the group consisting of a bio-polymer polyol and a bio-monomer polyol.

6. The polishing pad of claim 5, wherein the bio-polymer polyol comprises at least one selected from the group consisting of a bio-polyether polyol, a bio-polyester polyol, a bio-polycarbonate polyol, and a bio-polycaprolactam polyol.

7. The polishing pad of claim 5 or 6, wherein the bio-monomer polyol comprises at least one selected from the group consisting of bio-ethylene glycol, bio-diethylene glycol, bio-1,2-propylene glycol, bio-1,3-propanediol, bio-2-methyl-1,3-propanediol, bio-1,3-butanediol, bio-1,4-butanediol, bio-2,3-butanediol, bio-n-butanol, bio-isobutanol, bio-1,5-pentanediol, bio-2-octanol, bio-1,9-nonediol, bio-1,10-decanediol, bio-diethylene glycol, and bio-isosorbide.

8. The polishing pad of any of claims 3 to 7, wherein the isocyanate raw material comprises at least one selected from the group consisting of toluene diisocyanate (TDI) and 4,4'-methylenedicyclohexyl diisocyanate (H12MDI).

9. The polishing pad of any of claims 3 to 8, wherein the isocyanate raw material comprises a bio-isocyanate.

10. The polishing pad of any preceding claim, wherein the total biomass content of the polishing pad is 8 to 50% by weight.

11. A process for preparing a polishing pad, which comprises:

preparing a biomass-containing urethane prepolymer from a urethane prepolymer composition comprising an isocyanate raw material and a polyol raw material comprising a bio-polyol;

preparing a biomass-containing composition comprising the biomass-containing urethane prepolymer, a curing agent, and a foaming agent; and

curing the biomass-containing composition to prepare a top pad layer,

wherein the polishing pad has a total biomass content of 1 to 50% by weight as measured by the ASTM D 6866 standard.

[Fig. 1]

<u>100</u>

~10
~20
~30

Europäisches
Patentamt
European
Patent Office
Office européen
des brevets

# EUROPEAN SEARCH REPORT

Application Number

EP 24 16 3974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 891 735 A1 (TORAY INDUSTRIES [JP]) 8 July 2015 (2015-07-08) * paragraphs [0040], [0079], [0092]; table 1 * | 1-11 | INV. B24B37/24 |
| A | JP 2022 081047 A (DAINIPPON INK & CHEMICALS) 31 May 2022 (2022-05-31) * paragraphs [0007] - [0013], [0021] - [0031] * | 5-9 | |

TECHNICAL FIELDS SEARCHED (IPC)

B24B
C08G
H01L

The present search report has been drawn up for all claims

| Place of search | Date of completion of the search | Examiner |
|---|---|---|
| Munich | 26 July 2024 | Koller, Stefan |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...........................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 16 3974

This annex lists the patent family members relating to the patent documents cited in the above-mentioned European search report.
The members are as contained in the European Patent Office EDP file on
The European Patent Office is in no way liable for these particulars which are merely given for the purpose of information.

26-07-2024

| Patent document cited in search report | | Publication date | Patent family member(s) | | Publication date |
|---|---|---|---|---|---|
| EP 2891735 | A1 | 08-07-2015 | CN | 104520486 A | 15-04-2015 |
| | | | EP | 2891735 A1 | 08-07-2015 |
| | | | JP | 6248634 B2 | 20-12-2017 |
| | | | JP | WO2014034780 A1 | 08-08-2016 |
| | | | KR | 20150052007 A | 13-05-2015 |
| | | | TW | 201418536 A | 16-05-2014 |
| | | | US | 2015252524 A1 | 10-09-2015 |
| | | | WO | 2014034780 A1 | 06-03-2014 |
| JP 2022081047 | A | 31-05-2022 | CN | 114539500 A | 27-05-2022 |
| | | | JP | 2022081047 A | 31-05-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20180044771